# EUROPEAN PATENT APPLICATION

(11) **EP 4 797 904 A1**
(43) Date of publication of application: **26.08.2026**
(21) Application number: 25216335.7
(22) Date of filing: 17.11.2025
(51) Int. Cl.: H10D 30/66, H10D 62/10, H10D 64/23, H10D 64/62, H10W 20/40, H10D 62/832, H10D 64/27

(54) **TRANSISTOR WITH ACTIVE AREA UNDER GATE RUNNER**

(30) Priority: 24.02.2025 US 202519061440
(71) Applicant: Semiconductor Components Industries, LLC, Scottsdale, AZ 85250 (US)
(72) Inventor: FRANCHI, Jimmy Robert Hannes, 74598 Enköping, Uppland (SE)
(74) Representative: Manitz Finsterwald Patent- und Rechtsanwaltspartnerschaft mbB

(57) **Abstract**

A transistor is disclosed. The transistor includes a gate runner coupled to a gate of the transistor. The transistor also includes a source region and a silicide layer coupling a source metal to the source region. The silicide layer includes a silicide contact area located under the source metal and coupling the source metal to a first portion of the source region under the source metal, and a silicide extension area located under an insulator and providing a lateral coupling from the source metal to a second portion of the source region located under the insulator.

## Description

### TECHNICAL FIELD

The disclosure relates generally to semiconductor devices, and particularly to techniques for improving area utilization of power transistors.

### BACKGROUND

Power transistors may be used in power electronics, such as switching power converters and inverters. In some applications, a metal-oxide semiconductor field effect transistor (MOSFET or MOS transistor) may be formed as a discrete component included in an integrated circuit package. Bond wires may connect various terminals of the MOSFET die to the lead frame of the integrated circuit package. For example, a gate pad may be coupled to a gate terminal by a first set of one or more bond wires, and one or more source pads may be coupled to a source terminal by a second set of one or more bond wires. For vertical MOSFETs, a drain contact may be configured on the opposite side of the die as the respective gate and source pads, and may further couple to a drain terminal of the lead frame.

A gate runner may be used to provide a low-resistance path from the gate pad of the die to the gates of the various active cells of the MOSFET. Inventors of embodiments of the present disclosure have recognized that such gate runners consume area under which the active area of the device is excluded according to conventional techniques. Inventors of embodiments of the present disclosure have also recognized that such area consumption by the gate runner, at the expense of the active area of the MOSFET, may result in a larger size and cost to manufacture a MOSFET for a given on-state resistance value. Embodiments of the present disclosure may address one or more of these challenges.

### SUMMARY

According to one embodiment, transistor comprises a gate runner coupled to a gate of the transistor, a source region, a silicide layer coupling a source metal to the source region, wherein the silicide layer comprises a silicide contact area located under the source metal and coupling the source metal to a first portion of the source region under the source metal, and a silicide extension area located under an insulator and providing a lateral coupling from the source metal to a second portion of the source region located under the insulator. In some embodiments, the silicide extension area extends laterally under the gate runner. In some embodiments, the silicide extension area extends laterally under an entire width of the gate runner. In the same of different embodiments, the transistor is a silicon carbide transistor. In the same or different embodiments, the silicide layer comprises nickel silicide. In the same or different embodiments, the transistor is an NMOS transistor. In the same or different embodiments, the source metal and the gate runner are formed by different patterns of a first metal layer. In the same or different embodiments, the gate runner formed on the first metal layer is separated by a dielectric layer from a source pad on a second metal layer. In the same or different embodiments, the gate runner is disposed along a gate-runner axis orthogonal to a linear layout of a plurality of active cells of the transistor. In the same or different embodiments, the active cells of the transistor extend under the gate runner. In the same or different embodiments, the transistor further comprises one or more gate-runner vias coupling the gate runner on a first metal layer to a polysilicon gate. In the same or different embodiments, the one or more gate-runner vias include at least one linear via disposed along the gate-runner axis. In the same or different embodiments, the one or more gate-runner vias include a plurality of island vias disposed along the gate-runner axis.

According to another embodiment, a silicon carbide transistor comprises a gate runner coupled to a gate of the silicon carbide transistor, a source region formed in an silicon carbide substrate, and a silicide layer coupling a source metal to the source region, wherein the silicide layer comprises a silicide contact area located under the source metal and coupling the source metal to a first portion of the source region under the source metal, and a silicide extension area located under an insulator and providing a lateral coupling from the source metal to a second portion of the source region located under the insulator, wherein the silicide extension area extends laterally under the gate runner. In some embodiments, the silicide extension area extends laterally under an entire width of the gate runner. In the same or different embodiments, the gate runner is disposed along an axis orthogonal to a linear layout of a plurality of active cells of the transistor.

According to another embodiment, a transistor comprises (i) a source region, (ii) a silicide layer coupling a source metal to the source region, wherein the silicide layer comprises a silicide contact area located under the source metal and coupling the source metal to a first portion of the source region under the source metal, and a silicide extension area located under an insulator and providing a lateral coupling from the source metal to a second portion of the source region located under the insulator, and (iii) a gate runner coupled to a gate of the transistor, the gate runner disposed along an axis orthogonal to a linear layout of a plurality of active cells of the transistor, wherein the active cells of the transistor extend under the gate runner. In some embodiments, the transistor is a silicon carbide transistor. In the same or different embodiments, the silicide extension area extends laterally under the gate runner. In the same or different embodiments, the silicide extension area extends laterally under an entire width of the gate runner.

### BRIEF DESCRIPTION OF THE DRAWINGS

A more complete understanding of the present embodiments may be acquired by referring to the following description taken in conjunction with the accompanying drawings, in which like reference numbers indicate like features.
FIG. 1 illustrates a top view of a transistor in accordance with embodiments of the present disclosure.
FIG. 2A illustrates a top view of a transistor in accordance with embodiments of the present disclosure.
FIG. 2B illustrates a cross-section view of a transistor in accordance with embodiments of the present disclosure.
FIG. 2C illustrates a cross-section view of a transistor in accordance with embodiments of the present disclosure.
FIG. 2D illustrates a cross-section view of a transistor in accordance with embodiments of the present disclosure.
FIG. 2E illustrates a cross-section view of a transistor in accordance with embodiments of the present disclosure.
FIG. 3A illustrates a top view of a transistor in accordance with embodiments of the present disclosure.
FIG. 3B illustrates a cross-section view of a transistor in accordance with embodiments of the present disclosure.

### DETAILED DESCRIPTION

Details of one or more embodiments are set forth in the description below and the accompanying drawings. Other features will be apparent from the description, drawings, and from the claims. The embodiments disclosed should not be interpreted, or otherwise used, as limiting the scope of the disclosure, including the claims. In addition, one skilled in the art understands that the following description has broad application, and the discussion of any embodiment is meant to be exemplary of that embodiment, and not intended to intimate that the scope of the disclosure, including the claims, is limited to that embodiment.

Various terms are used to refer to particular system components. Different companies may refer to a component by different names, and this disclosure does not intend to distinguish between components that differ in name but not form and function. In the following discussion and in the claims, the terms "including" and "comprising" are used in an open-ended fashion, and thus should be interpreted to mean "including, but not limited to." Also, the term "couple" or "coupled" is intended to mean either an indirect or direct connection. Thus, if a first device couples to, or is coupled to, a second device, that connection between the first device and the second device may be through a direct connection or through an indirect connection via other elements and connections.

Embodiments disclosed herein may include a transistor. The transistor may be a metal-oxide semiconductor field-effect transistor (MOSFET). In some embodiments, the transistor may be a silicon carbide transistor. In other embodiments, the transistor may be implemented in silicon, gallium nitride, or any other suitable semiconductor material. The transistor may include a gate runner implemented on a first metal layer. The gate runner may, in conjunction with various vias and/or contacts, provide a low-resistance path from a gate pad to a polysilicon gate of the transistor. In some embodiments, including embodiments implemented with a single metal layer, the gate pad may be included on the same first metal layer as the gate runner but at a different die location than the gate runner. In other embodiments, including embodiments implemented with two or more metal layers, the gate pad may be located on a higher second metal layer. The transistor may also include a source metal implemented on the first metal layer. In some embodiments, including embodiments implemented with a single metal layer, the source metal may be coupled to a source pad implemented on the first metal layer. In other embodiments, including embodiments implemented with two or more metal layers, the source metal on the first metal layer may be coupled to further source metal and/or a source pad on a second metal layer.

The source metal on the first metal layer may also contact the source region of the active cells of the transistor. In some embodiments, transistor may further include a silicide layer to improve the coupling between the source metal and the source region. The silicide layer may, for example, improve the electrical conductivity of the contact between the source region and the source metal of the transistor. As described in further detail below, the silicide layer may include a silicide contact area and a silicide extension area. The silicide contact area may be located under the source metal and may couple the source metal to a first portion of the source region under the source metal. In addition, the silicide extension area may extend under an insulator that insulates the source region from the gate runner implemented on the first metal layer. The silicide extension area may thus provide a lateral coupling from the source metal to a second portion of the source region located under the insulator and under the gate runner. Accordingly, the active area of the transistor may be extended under the gate runner.

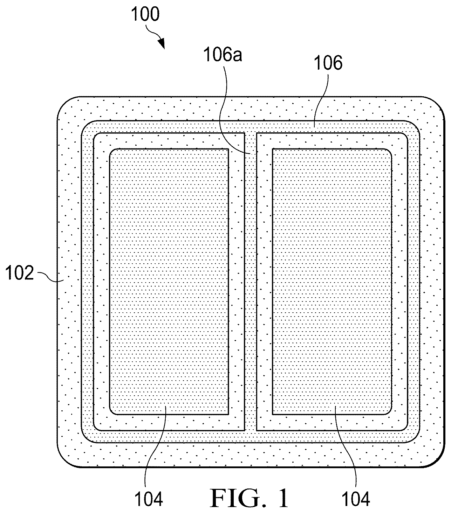

FIG. 1 illustrates a top view of transistor 100 in accordance with embodiments of the present disclosure. Specifically, FIG. 1 illustrates a top view of a first metal layer of transistor 100. In some embodiments, transistor 100 may include dielectric layer 102 separating different patterns of a first metal layer that may form source metal 104 and gate runner 106. In some embodiments, dielectric layer 102 may include silicon dioxide or any other dielectric material suitable to electrically isolate source metal 104 from gate runner 106. Source metal 104, in conjunction with one or more contacts and/or one or more vias, may be utilized to couple the source region of underlying active cells of transistor 100 to a source pad, for example, on a higher second layer of metal. Gate runner 106, in conjunction with one or more contacts and/or one or more vias, may be utilized to couple polysilicon gates of various active cells of transistor 100 to a gate pad, for example, on a higher second layer of metal.

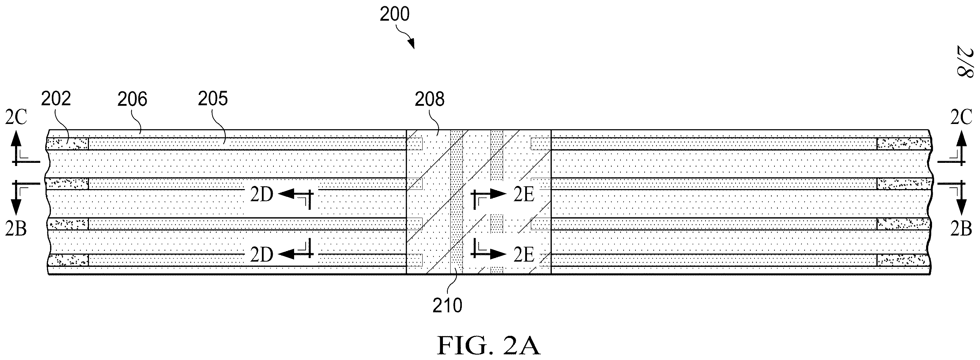

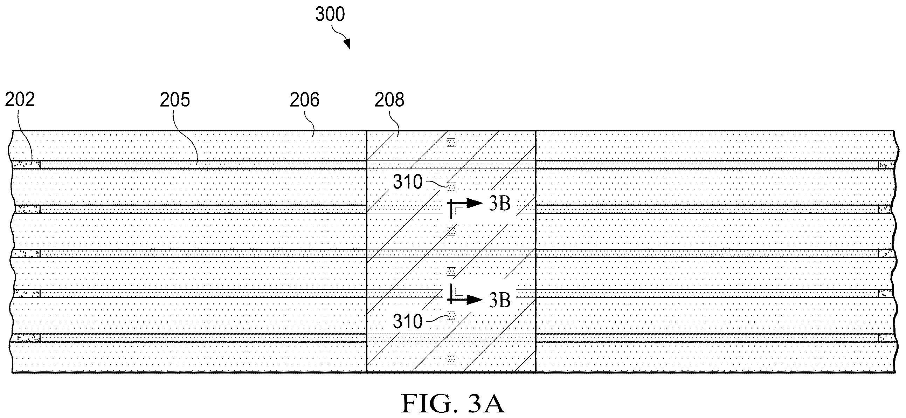

As shown in FIG. 1, gate runner 106 may include a gate-runner bar 106a. In some embodiments, portions of gate runner 106, including for example gate-runner bar 106a, may be disposed along an axis orthogonal to a layout of a plurality of active cells of the transistor. As described below with reference to FIG. 2A through FIG. 2E and FIG. 3A through FIG. 3B, embodiments disclosed herein may include a silicide extension area to extend the coupling of the source metal to a portion of the source region located underneath a gate runner, thereby utilizing space under the gate runner for active area of the transistor. Accordingly, a gate runner may be implemented to improve the gate resistance of the transistor without sacrificing active area of the transistor.

FIG. 2A illustrates a top view of transistor 200 in accordance with embodiments of the present disclosure. Specifically, FIG. 2A illustrates a top view of transistor 200 zoomed in on a portion of gate runner 208 traversing above and across active cells of transistor 200.

As shown in FIG. 2A, gate runner 208 may be disposed along a gate-runner axis orthogonal to a linear layout of the plurality of active cells of transistor 200. Transistor 200 may include one or more gate-runner vias 210 coupling gate runner 208 on a first metal layer to a polysilicon gate of transistor 200. For example, gate-runner vias 210 may couple gate runner 208, which may be disposed on a first metal layer, to an underlying polysilicon layer that may form the gate of the various active cells of transistor 200. The one or more gate-runner vias 210 may include at least one linear via disposed along the gate-runner axis. For example, as shown in FIG. 2A, gate-runner vias 210 may extend linearly with gate runner 208 and may be disposed, similar to gate runner 208, along a gate-runner axis orthogonal to the linear layout of the plurality of cells of transistor 200.

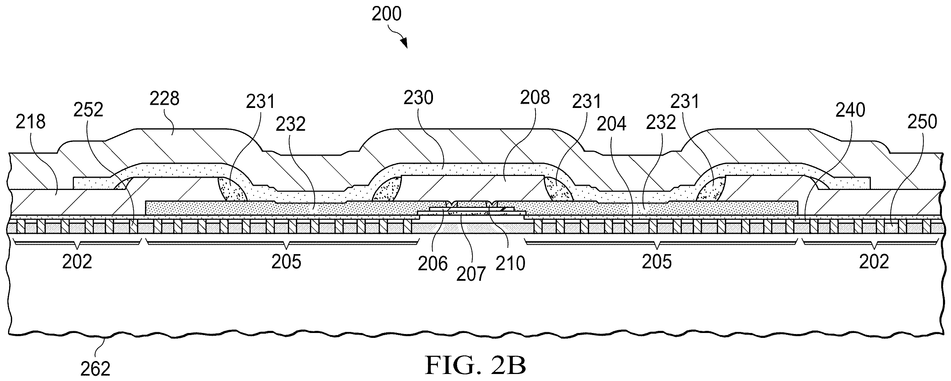

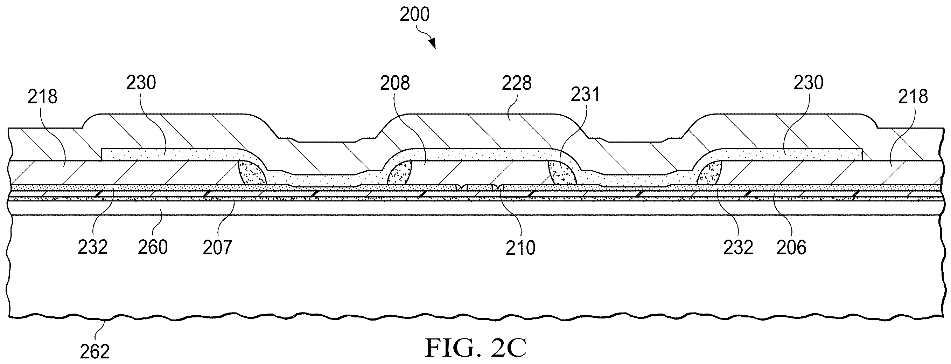

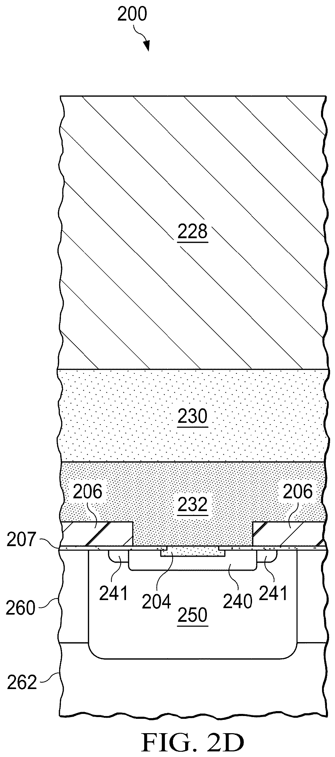

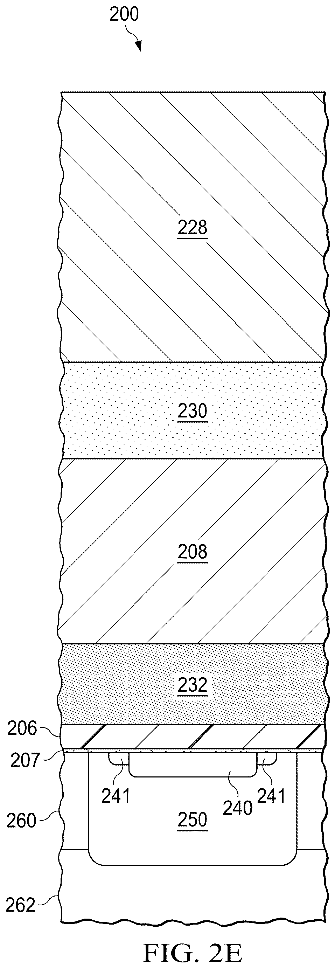

The source region for each of the plurality of active cells may be coupled to above layers of source metal (not shown in FIG. 2A) in a manner that allows the active cells to extend under gate runner 208. Specifically, transistor 200 may include a silicide layer coupling a source metal to the source region for each of the plurality of active cells of transistor 200. The silicide layer may include a silicide contact area 202 and a silicide extension area 205. As described in further detail below with reference to FIG. 2B, silicide contact area 202 may be located under the source metal and may couple the source metal to a first portion of the source region under the source metal. Further, silicide extension area 205 may be located under an insulator and may provide a lateral coupling from the source metal to a second portion of the source region located under the insulator. The source metal, the silicide layer, the source region, the insulator, and the gate runner are described in further detail below with reference to FIGS. 2B, 2C, 2D, and 2E, which provide various cross-section views of transistor 200 corresponding to cutlines 2B, 2C, 2D, and 2E in FIG. 2A.

FIG. 2B illustrates a cross-section view of transistor 200 in accordance with embodiments of the present disclosure. Specifically, FIG. 2B illustrates a cross-section view of transistor 200 along cutline 2B in FIG. 2A, which follows the source region along the linear layout of one of the plurality of cells of transistor 200.

As shown in FIG. 2B, transistor 200 may include source region 240 disposed within well region 250, which may in turn be disposed in epitaxial region 262. In some embodiments, transistor 200 may be a n-type metal-oxide semiconductor field-effect transistor (n-type MOSFET or NMOS transistor). In such embodiments where transistor 200 is an NMOS transistor, epitaxial region 262 may be an n-type epitaxial region, well region 250 may be a p-doped well region, and source region 240 may be an n-doped source region. In some embodiments, epitaxial region 262 may further couple to an n-type substrate, which may form the drain of transistor 200. Transistor 200 may further include heavily doped p-type body-contact regions 252 configured to couple the body of transistor 200, formed by well region 250, to the source of transistor 200.

In some embodiments, transistor 200 may be a silicon carbide transistor. For example, epitaxial region 262 may be a silicon carbide epitaxy grown on a silicon carbide substrate. For the purposes of the present disclosure, epitaxial region 262 may also be referred to as a substrate, or for example, a semiconductor substrate or a silicon carbide substrate. In such embodiments, source region 240 may be formed in the silicon carbide substrate along with well region 250 and body-contact regions 252 (and JFET region 260 described below with reference to the cross-section views of FIGS. 2C-2E). Well region 250, source region 240, and body-contact regions 252 may each be implemented by doping the silicon carbide epitaxy or substrate with the respective p-type or n-type doping as described directly above. In other embodiments, transistor 200 may be formed on a different type of semiconductor substrate, such as silicon or gallium nitride (GaN).

Gate runner 208 may be coupled to the gate of transistor 200. In embodiments where transistor 200 is a silicon carbide transistor, gate runner 208 may be couple to the gate of the silicon carbide transistor. For example, as shown in FIG. 2B, gate runner 208 may be coupled by gate-runner vias 210 to polysilicon layer 206. In some embodiments, polysilicon layer 206 may be formed for example with a heavily doped n-type polysilicon. As described above with reference to the top view of FIG. 2A, and as further described below with reference to the cross-section view of FIG. 2D, portions of polysilicon layer 206 may form the gates of various active cells of the transistor 200.

As shown in FIG. 2B, gate runner 208 may be formed on a first metal layer. Transistor 200 may also include source metal 218 formed on the first metal layer. For example, source metal 218 and gate runner 208 may be formed by different patterns of the first metal layer separated by insulator 232, dielectric spacers 231, and dielectric layer 230.

Silicide layer 204 may couple source metal 218 to source region 240. Silicide layer 204 may improve the electrical conductivity of the contact between source region 240 and source metal 218. In some embodiments, silicide layer 204 may comprise, for example, nickel silicide. During manufacturing, silicide layer 204 may be formed by depositing thin layer of metal, such as nickel, over active areas of transistor 200 including source region 240. Heat may be applied to cause the thin layer of metal such as nickel to react with the underlying semiconductor material at the surface of source region 240 to form silicide layer 204. In other embodiments, other metals may be utilized to form silicide layer 204, including for example, copper, aluminum, titanium, or any other metal suitable to react with the semiconductor material at the surface of source region 240 to form a silicide.

As shown in FIG. 2B, silicide layer 204 may include silicide contact area 202 and silicide extension area 205. Silicide contact area 202 may be the portion of silicide layer 204 located under source metal 218. For example, silicide contact area 202 may be located under source metal 218 and may couple source metal 218 to a first portion of source region 240 under source metal 218. In some embodiments, further contact layers, such as a thin titanium layer, may also be included between silicide layer 204 and source region 240 and may further improve the conductivity of the coupling between source metal 218 and underlying portions of source region 240. Thus, for the purposes of the present disclosure, when referring to the silicide contact area 202 being located under source metal 218, such reference may include further intermediate conductive layers such as a thin titanium contact layer between source metal 218 and silicide contact area 202.

As shown in FIG. 2B, insulator 232 may help electrically insulate gate runner 208 from underlying portions of source region 240. Insulator 232 may be, for example, a borophosphosilicate glass (BPSG) film formed by chemical vapor deposition (CVD), or any other dielectric suitable to electrically insulate gate runner 208 from underlying portions of source region 240. In addition, dielectric spacers 231 may abut the sides of both gate runner 208 and source metal 218, thereby further insulating gate runner 208 from source metal 218. In some embodiments, dielectric spacers 231 may be formed with silicon dioxide, or any other dielectric material suitable to help electrically insulate the sides of gate runner 208 and source metal 218. Further, gate runner 208 formed on the first metal layer may be separated by dielectric layer 230 from source pad 228 on the second metal layer. Dielectric layer 230 may be formed with silicon dioxide for example, or any other dielectric material suitable to electrically insulate gate runner 208 from source pad 228 on the second metal layer. In some embodiments, dielectric layer 230 may be deposited above the first metal layer and patterned. As shown in FIG. 2B, dielectric layer 230 may be patterned to electrically insulate gate runner 208 from source pad 228 while allowing source metal 218 on the first metal layer to couple to source pad 228 on the second metal layer. Although the embodiment of transistor 200 illustrated in FIG. 2B illustrates source pad 228 implemented on the second metal layer, some embodiments of transistor 200 may be implemented with a single metal layer. In such embodiments, source metal 218 may be coupled to a source pad implemented on the first metal layer at a different die location. Further, in such embodiments, insulator 232, alone or in combination with other insulating layers such as dielectric layer 230, may electrically insulate gate runner 208 from source region 240, silicide layer 204, and/or source metal 218.

As shown in FIG. 2B, silicide extension area 205 may extend laterally under gate runner 208 and insulator 232. Silicide extension area 205 may thus provide a lateral coupling from source metal 218 to a second portion of source region 240 located under insulator 232 and under gate runner 208. Silicide extension area 205 may thus electrically couple portions of source region 240 under gate runner 208 to source metal 218. As such, the active cells of transistor 200 may extend under gate runner 208. Gate runner 208 may thus be implemented without sacrificing active area of transistor 200.

FIG. 2C illustrates a cross-section view of transistor 200 in accordance with embodiments of the present disclosure. Specifically, FIG. 2C illustrates a cross-section view of transistor 200 along cutline 2C in FIG. 2A, which follows the JFET region between two active cells of transistor 200 along the linear layout of those active cells of transistor 200.

As shown in FIG. 2C, gate runner 208 may be coupled by gate-runner vias 210 to polysilicon layer 206. Gate-runner vias 210 may form contacts through insulator 232 through which gate runner 208 and polysilicon layer 206 may be electrically coupled. For example, gate-runner vias 210 may be formed by tungsten, copper, aluminum, or any other metal or metal alloy suitable to electrically couple gate runner 208 to polysilicon layer 206. In some embodiments, polysilicon layer 206 may be formed for example with a heavily doped n-type polysilicon. And as described above with reference to FIG. 2A, portions of polysilicon layer 206, including the portion of shown in the cross-section view of FIG. 2C, may form the gate of the active cells of transistor 200.

In the cross-section view of FIG. 2C, a gate oxide layer 207 may be disposed between the polysilicon layer 206 forming the gate of transistor 200 and the underlying JFET region 260 of the semiconductor substrate. Gate oxide layer 207 may be formed by a dielectric material, such as silicon dioxide, or any other dielectric material suitable to form the gate oxide of transistor 200. In some embodiments, JFET region 260 may have a heavier doping, of the same conductivity type, as epitaxial region 262. For example, in embodiments where transistor 200 is an NMOS transistor and epitaxial region 262 is a n-type epitaxial region, JFET region 260 may also be an n-type region at a higher n+ doping level than epitaxial region 262. During operation, electrons may flow from source metal 218 and through source region 240 (shown in FIG. 2B), through the channel under the gate in well region 250, and into JFET region 260 (shown in FIG. 2C), and then down through epitaxial region 262 toward the drain contact on the bottom-side of the semiconductor substrate.

As shown in FIG. 2C, the JFET region 260 under the gate of transistor 200 may extend across the entire cross-section of FIG. 2C, including under gate runner 208. Thus, as also described above with reference to FIG. 2B, the active cells of transistor 200 may extend under gate runner 208. Gate runner 208 may thus be implemented to improve the gate resistance of transistor 200 without sacrificing active area of transistor 200.

FIG. 2D illustrates a cross-section view of transistor 200 in accordance with embodiments of the present disclosure. Specifically, FIG. 2D illustrates a cross-section view of transistor 200 along cutline 2D in FIG. 2A, which slices an active cell of transistor 200 at a location corresponding to silicide extension area 205.

As shown in FIG. 2D, source region 240 may be disposed within well region 250, which in turn may be disposed within epitaxial region 262. JFET region 260 may be disposed to the side of well region 250. In some embodiments, the depth of JFET region 260 may be less than the depth of well region 250. Polysilicon layer 206 may be disposed above gate oxide layer 207 at a location extending from source region 240, across low-doped region 241, and across a portion of well region 250 to and/or abutting JFET region 260. During operation, when a threshold voltage is applied to the gate formed by polysilicon layer 206, a conduction channel may thus be formed under the gate and through low-doped region 241 and the area of well region 250 located laterally between source region 240 and JFET region 260. Electrons may thus flow from source region 240, through low-doped region 241 and well region 250, into JFET region 260, and down through epitaxial region 262 toward the drain contact on the bottom-side of the semiconductor substrate.

The cross-section view of FIG. 2D is placed at a location corresponding to the silicide extension area 205 described above with reference to FIG. 2A and FIG. 2B. Thus, as shown in FIG. 2D, silicide layer 204 is located under insulator 232. Nonetheless, the source current from the portions of source region 240 under insulator 232 may conduct through source region 240 itself as well as through silicide layer 204. For example, silicide layer 204 may conduct (for example into the page with respect to the cross-section view of FIG. 2D) from a silicide extension area 205 to a silicide contact area 202 where silicide layer 204 contacts source metal 218 (as shown in FIG. 2B).

FIG. 2E illustrates a cross-section view of transistor 200 in accordance with embodiments of the present disclosure. Specifically, FIG. 2E illustrates a cross-section view of transistor 200 along cutline 2E in FIG. 2A, which slices an active cell of transistor 200 at a location under gate runner 208.

As shown in FIG. 2E, source region 240 may be disposed within well region 250, which in turn may be disposed within epitaxial region 262. JFET region 260 may also be disposed within epitaxial region 262 to the side of well region 250. Polysilicon layer 206 may be disposed above gate oxide layer 207, including at a location extending from above source region 240, above low-doped region 241, and over a portion of well region 250 to and/or abutting JFET region 260. During operation, when a threshold voltage is applied to the gate formed by polysilicon layer 206, a channel may thus be formed under the gate and through low-doped region 241 and the area of well region 250 located laterally between source region 240 and JFET region 260. Electrons may thus flow from source region 240, through low-doped region 241 and well region 250, into JFET region 260, and down through epitaxial region 262 toward the drain contact on the bottom-side of the semiconductor substrate.

The cross-section view of FIG. 2E is placed at a location under gate runner 208. Thus, the area of source region 240 illustrated in the cross-section view of FIG. 2E may be located under gate oxide layer 207 as opposed to a silicide layer 204 or source metal 218. Nonetheless, source current from portions of source region 240 under gate oxide layer 207 may conduct through source region 240 itself and to a further portion of source region 240 where the majority of the source current may be conducted by a silicide extension area 205 of silicide layer 204, and to a silicide contact area 202 of silicide layer 204 where contact may be made to source metal 218.

As described above, transistor 200 may in some embodiments be a silicon carbide transistor. Because the implant regions of a silicon carbide transistor may have low gain, embodiments of transistor 200 implemented in silicon carbide may be immune from a turn-on of a parasitic bipolar transistor that may otherwise occur when source and body contacts are multiple microns away from the nearest metal contact. Thus, as shown in FIG. 2E, the active area of transistor 200, including source region 240, may be extended under a gate runner that may be, for example, on the order of tens of microns wide.

FIG. 3A illustrates a top view of transistor 300 in accordance with embodiments of the present disclosure. Specifically, FIG. 3A illustrates a top view of transistor 300 zoomed in on a portion of gate runner 208 traversing across active cells of transistor 300.

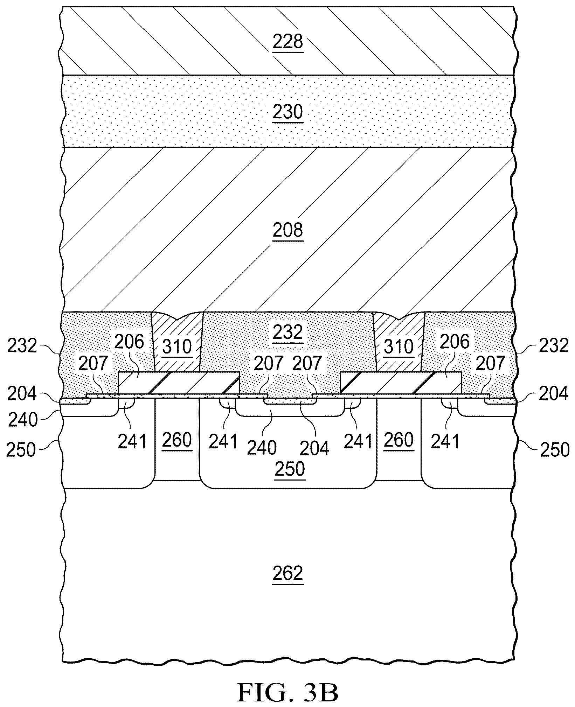

Transistor 300 shown in FIG. 3A and FIG. 3B may represent an alternative embodiment of transistor 200 described above with reference to FIG. 2A through FIG. 2E. For example, transistor 300 may be formed in a similar manner as transistor 200, and may include similar elements such as epitaxial region 262, JFET region 260, well region 250, source regions 240, a silicide layer 204 including a silicide contact area 202 and a silicide extension area 205, low-doped regions 241, gate oxide layer 207, a polysilicon layer 206 forming the gates of the active cells of transistor 300, insulator 232, a first metal layer on which source metal 218 and gate runner 208 are formed, dielectric layer 230, and a second metal layer on which source pad 228 is formed.

As shown in FIG. 3A, gate runner 208 may be disposed along a gate-runner axis orthogonal to a linear layout of the plurality of active cells of transistor 300. Transistor 300 may include one or more gate-runner vias 310 coupling gate runner 208 on a first metal layer to a polysilicon gate of transistor 300. For example, gate-runner vias 310 may couple gate runner 208, which may be disposed on a first metal layer, to a polysilicon layer 206 that may form the gate of the various active cells of transistor 300. In some embodiments, gate-runner vias 310 may be formed by tungsten, copper, aluminum, or any other metal or metal alloy suitable to electrically couple gate runner 208 to polysilicon layer 206. The one or more gate-runner vias 310 may include a plurality of island vias disposed along the gate-runner axis following gate runner 208. For example, as shown in FIG. 3A, a plurality of gate-runner vias 310 may each have an island shape and may be respectively disposed, similar to gate runner 208, along the gate-runner axis orthogonal to the linear layout of the plurality of cells of transistor 300.

As also shown in FIG. 3A, the silicide extension area 205 may extend laterally under an entire width of gate runner 208. The island shape of the plurality of gate-runner vias 310 may facilitate the reach of silicide extension area 205 under an entire width of gate runner 208. For example, by forming gate-runner vias 310 in island shapes, the silicide extension area 205 of silicide layer 204 may be extended between areas of the gate-runner vias 310 and thus under an entire width of gate runner 208.

FIG. 3B illustrates a cross-section view of transistor 300 in accordance with embodiments of the present disclosure. Specifically, FIG. 3B illustrates a cross-section view of transistor 300 along cutline 3B in FIG. 3A, which slices active cells of transistor 300 across multiple gate-runner vias 310 under gate runner 208.

During operation, when a threshold voltage is applied to the gate formed by polysilicon layer 206, a conduction channel may be formed under the gate and through low-doped region 241 and the area of well region 250 located laterally between source region 240 and JFET region 260. Electrons may thus flow from source region 240, through low-doped region 241 and well region 250, into JFET region 260, and down through epitaxial region 262 toward the drain contact on the bottom-side of the semiconductor substrate.

The island shape of gate-runner vias 310 allows the active areas of transistor 300, including JFET region 260, well region 250, source region 240, low-doped region 241, to pass through (going into the page in the cross-section view of FIG. 3B) and under gate runner 208. Likewise, silicide layer 204 may pass through and under gate runner 208 while being electrically isolated from gate runner 208 by insulator 232 and gate oxide layer 207. The portion of silicide layer 204 under insulator 232 may thus form silicide extension area 205, which as described above with reference to FIG. 3A, may extend laterally (into the page in the cross-section view of FIG. 3B) under an entire width of gate runner 208. Silicide extension area 205 of silicide layer 204 may thus provide a low-resistance path for the source current through areas of the source region under insulator 232 and/or under the entire width of gate runner 208. Gate runner 208 may thus be implemented to lower the gate resistance of transistor 300 without sacrificing the active area of transistor 300.

Although examples have been described above, other modifications and variations may be made from this disclosure without departing from the spirit and scope of these examples. The above descriptions of various embodiments illustrate the principles of the invention. Numerous variations and modifications will become apparent to those skilled in the art based on the above disclosure. The following claims are intended to embrace all such variations and modifications.

## Claims

1. A transistor, comprising:
a gate runner coupled to a gate of the transistor;
a source region; and
a silicide layer coupling a source metal to the source region, wherein the silicide layer comprises:
a silicide contact area located under the source metal and coupling the source metal to a first portion of the source region under the source metal; and
a silicide extension area located under an insulator and providing a lateral coupling from the source metal to a second portion of the source region located under the insulator.

2. The transistor of claim 1, wherein the silicide extension area extends laterally under the gate runner.

3. The transistor of claim 1, wherein the silicide extension area extends laterally under an entire width of the gate runner.

4. The transistor of claim 1, wherein the transistor is a silicon carbide transistor.

5. The transistor of claim 1, wherein the silicide layer comprises nickel silicide.

6. The transistor of claim 1, wherein the transistor is an NMOS transistor.

7. The transistor of claim 1, wherein the source metal and the gate runner are formed by different patterns of a first metal layer.

8. The transistor of claim 7, wherein the gate runner formed on the first metal layer is separated by a dielectric layer from a source pad on a second metal layer.

9. The transistor of claim 1, wherein the gate runner is disposed along a gate-runner axis orthogonal to a linear layout of a plurality of active cells of the transistor.

10. The transistor of claim 9, wherein the active cells of the transistor extend under the gate runner.

11. The transistor of claim 9, further comprising one or more gate-runner vias coupling the gate runner on a first metal layer to a polysilicon gate.

12. The transistor of claim 11, wherein the one or more gate-runner vias include at least one linear via disposed along the gate-runner axis.

13. The transistor of claim 11, wherein the one or more gate-runner vias include a plurality of island vias disposed along the gate-runner axis.

14. A silicon carbide transistor, comprising:
a gate runner coupled to a gate of the silicon carbide transistor;
a source region formed in an silicon carbide substrate; and
a silicide layer coupling a source metal to the source region, wherein the silicide layer comprises:
a silicide contact area located under the source metal and coupling the source metal to a first portion of the source region under the source metal; and
a silicide extension area located under an insulator and providing a lateral coupling from the source metal to a second portion of the source region located under the insulator, wherein the silicide extension area extends laterally under the gate runner.

15. The silicon carbide transistor of claim 14, wherein the silicide extension area extends laterally under an entire width of the gate runner.
